# EUROPÄISCHE PATENTSCHRIFT

(11) **EP 1 168 813 B1**
(45) Veröffentlichungstag und Bekanntmachung des Hinweises auf die Patenterteilung: **02.12.2009**
(21) Anmeldenummer: 01114742.8
(22) Anmeldetag: 22.06.2001
(51) Int. Cl.: H04N 1/191

(54) **Kompakte Mehrstrahllaserlichtquelle und Interleafrasterscanlinien-Verfahren zur Belichtung von Druckplatten**
Compact multibeam laser light source and raster scan line interleaving method for exposing printing plates
Source laser d'illumination à plusieurs faisceaux et procédé d'entrelacement de lignes de balayage à trame pour l'exposition de plaques d'impression

(30) Priorität: 30.06.2000 DE 10031915
(43) Veröffentlichungstag der Anmeldung: 02.01.2002
(73) Patentinhaber: Heidelberger Druckmaschinen Aktiengesellschaft, 69115 Heidelberg (DE)
(72) Erfinder: Beier, Bernard, Dr., 68526 Ladenburg (DE); Ernst, Uwe, 68163 Mannheim (DE); Vosseler, Bernd, 69120 Heidelberg (DE)
(74) Vertreter: Fey, Hans-Jürgen

(56) Entgegenhaltungen:
- EP-A- 0 687 992
- EP-A- 0 783 223
- EP-A2- 0 422 926
- US-A- 4 401 991
- US-A- 5 036 519
- US-A- 5 233 367
- US-A- 5 375 111
- US-A- 5 589 870
- ANONYMOUS: "Laser Diodes Single-Stripe CW Devices: 645 to 655 nm Devices" INTERNET ARTICLE, [Online] 1999, XP002297927 Gefunden im Internet: URL:http://www.pacer.co.uk/img/pdfs/645-65 5-single-stripe.pdf> [gefunden am 2004-09-24]

## Beschreibung

Die vorliegende Erfindung betrifft eine Vorrichtung zur Bebilderung von Druckplatten mit einem Array von *n* Laserdioden.

Seit geraumer Zeit sind Vorrichtungen und Verfahren bekannt, mit welchen die Bebilderung einer Druckplatte, sei es eine ebene oder gekrümmte Fläche, vermittels Belichtung mit Laserstrahlung möglich ist. Derartige Vorrichtungen und Verfahren kommen insbesondere in sogenannten CtP-Systemen, Computer-to-Plate, oder Direct Imaging Druckwerken oder Druckmaschinen zur Herstellung von Offset-Druckformen zum Einsatz.

Zur Zeit werden zur Bebilderung von Druckplatten vor allem Laserdiodensysteme eingesetzt, die aufgrund ihrer systemimmanenten Eigenschaften nicht die physikalischen Grenzen der Strahlqualität erreichen. Insbesondere ist durch die geringe Strahlqualität die Tiefenschärfe begrenzt, sodass bei hohen Auflösungen oft ein Autofokussystem verwendet werden muss. Zur Zeit werden zur Vielstrahlbebilderung, d. h. zur simultanen Belichtung von mehreren Bildpunkten, auf verschiedenen Medien, wie Druckplatten, Filmen, Datenträgern oder ähnlichem, insbesondere zwei verschiedene Konzepte verwendet: Einerseits kann die Strahlung einzelner Laserdioden oder eines Arrays von Laserdioden über optische Elemente, wie Linsen, Spiegel oder Fasern, dem zu bebildernden Medium direkt zugeführt werden. Andererseits kann die Strahlung aus einer Laserlichtquelle, typischerweise Laserdiodenbarren, über diverse optische Elemente auf ein Array von *n* Modulatoren abgebildet werden. Typischerweise handelt es sich dabei um elektrooptische oder akustooptische Modulatoren. Die einzelne Ansteuerung der *n* Modulatoren ermöglicht die Selektion einzelner Strahlen aus der gesamten Strahlung und die Modulation deren Leistung. Die selektierten, leistungsmodulierten Strahlen werden über weitere optische Elemente dem zu bebildernden Medium zugeführt.

In der EP 0 878 773 A2 wird ein optisches System offenbart, um ein Array von Lichtquellen, insbesondere ein individuell adressierbares Array von Laserdioden, auf eine Schreibfläche abzubilden. Es handelt sich dabei, um Breitstreifenlaserdioden, deren Emitterbreite erheblich größer als ihre Emitterhöhe ist. Typischerweise ist die Emissionsregion etwa 1 Mikrometer hoch und 60 Mikrometer breit. Das optische System besteht aus einer Anordnung von nicht-anamorphotischen Abbildungslinsen und einer Zylinderlinse, welche zwischen dem Array und dem Abbildungslinsensystems platziert ist, und bildet die Laserstrahlung auf die Schreibfläche ab. Typischerweise liegt diese Fläche nicht in den Foki der Laserstrahlen, sodass eine Verbreiterung der kurzen Dimension der abgebildeten Emissionsfläche auftritt.

Die US 5,521,748 offenbart eine Anordnung zum Schreiben von Bilddaten mit einem einzelnen Laser oder einem Array von Dioden und einem Lichtmodulator. Das vom Laser oder vom Array ausgesendete Licht wird auf einen Modulator abgebildet, welcher eine Linie reflektierender oder transmittierender lichtmodulierender Elemente aufweist. Nach erfolgter Selektion und Leistungsmodulation wird die Strahlung auf eine Oberfläche, welche lichtempfindliches Material aufweist, abgebildet, sodass einzelne Bildpunkte entstehen. Um auf eine ganze zweidimensionale Fläche derartige Bildpunkte zu legen, ist eine relative Bewegung der Bildpunkte zum lichtempfindlichen Material vorgesehen. Im Zusammenspiel der Erzeugung einzelner Punkte und der relativen Bewegung werden dann auf die zweidimensionale Fläche die gewünschten Bilddaten geschrieben. Auf einer zylindrischen Anordnung kann dabei die relative Bewegung zwischen den vom Lichtmodulator ausgehenden Lichtstrahlen und dem lichtempfindlichen Material derart erfolgen, dass Linien meanderförmig entlang der Symmetrieachse des Zylinders geschrieben werden oder dass Linien den Zylinder schraubenförmig umlaufen.

US 5,691,759 beschreibt eine Mehrstrahllaserlichtquelle, welche Rasterscanlinien im sogenannten Interleafrasterscanlinien-Verfahren auf ein Medium schreibt. Das Interleafrasterscanlinien-Verfahren zeichnet sich durch folgenden Eigenschaften aus. Eine Laserlichtquelle emittiert Strahlung, aus welcher *n* Bildpunkte mit modulierter Leistung durch entsprechende Abbildungsoptik und Modulation erzeugt wird. Diesen Bildpunkte sind auf einer Linie angeordnet, und der Abstand zweier benachbarter Punkte beträgt (*n* + 1) *p*, wobei *p* den Abstand der Druckpunkte bezeichnet. Zwischen Medium und Bildpunkten ist eine relative Bewegung in beiden, die Fläche des Mediums aufspannenden Richtungen vorgesehen. Nach erfolgtem Bebildern von *n* Punkten erfolgt eine relative Verschiebung des Mediums zu den Bildpunkten mit einer Translationskomponente senkrecht zu der durch die Achse der Bildpunkte definierten Richtung, sodass an einer anderen Stelle des Mediums erneut *n* Punkte geschrieben werden können. Dadurch entstehen sogenannte Scanlinien von Bildpunkten, zunächst im Abstand (*n* + 1) *p*, welche durch Laserstrahlung, deren Leistung entsprechend der Bildinformation moduliert ist, erzeugt werden. Nach Abschluss eines Scans mit einer Translationskomponente in senkrechter Richtung erfolgt eine Verschiebung parallel zu der durch die Achse der *n* Bildpunkte definierten Richtung um die Strecke (*n* x *p).* Die *n* Bildpunkte werden nun erneut mit einer Translationskomponente senkrecht zu der durch die Achse der Bildpunkte definierten Richtung auf der Oberfläche verschoben, sodass weitere Scanlinien entstehen. Jede Rasterscanlinie ist also von ihrer direkten Nachbarin durch den Abstand *p* der Druckpunkte getrennt. In dieser Weise mehrere optische Strahlen einer Laserlichtquelle benutzend, wird eine Überlappung der Scanlinien (Interleafrasterscanlinien-Verfahren) erreicht.

Ein erweitertes Interleafrasterscanlinien-Verfahren für eine Mehrstrahllaserlichtquelle wird in der EP 0 947 950 A2 dargestellt. Für den Fall von *n* Bildpunkten mit einem Abstand *p* der Druckpunkte, deren jeweils benachbarte Bildpunke um die Strecke (*q* x *n* + 1) *p*, wobei *q* eine natürliche Zahl ist, getrennt sind, ergibt sich eine Schrittweite, um die das Medium zwischen der Beschriftugn zweier Scanlinien bewegt werden muss, von *n* × *p.* In dieser Weise wird eine Überlappung (Interleaf) der Scanlinien erreicht, mit anderen Worten die neuen Scanlinien werden zwischen die alten Scanlinien geschrieben. Mit der entsprechenden Wahl der Verschiebung parallel zu der durch die Bildpunkten definierten Achse um die Strecke *n* x *p* ist dann eine Bebilderung möglich, ohne dass eine Stelle, an welche Bildinformation zu schreiben ist, mehrfach von einem Bildpunkt eines Lasers berührt wird. Das beschriebene Verfahren zeichnet sich dadurch aus, dass jeweils benachbarte Bildpunkte der Laserdioden weiter voneinander getrennt sind als die Weite der Verschiebung, um welche das Medium zwischen alten und neuen Scanlinien bewegt wird.

Die verschiedenen bekannten Einrichtungen weisen diverse Nachteile auf. Die von Breitstreifenlaserdioden, Laserdiodenbarren und Laserdiodenstacks emittierte Strahlung weist eine geringe Strahlqualität, quantifiziert durch die Beugungsmaßzahl M², auf. Die erreichbare Tiefenschärfe trotz Korrektur ist nur zu einer Bebilderung mit geringer Auflösung, typischerweise 1270 dpi, geeignet. Für die Erzeugung von sehr kleinen Druckpunkten, beispielsweise Auflösungen um 2540 dpi, ist deshalb ein Autofokussystem notwendig, welches einen aufwendigen mechanischen und elektrischen Aufbau benötigt. Für den Fall, dass Lichtquelle und Modulator getrennt sind, entsteht ein erhöhter Bedarf an optischen, elektronischen und mechanischen Komponenten sowie ein großer Bauraumbedarf. Es müssen viele Komponenten justiert werden, und die Lebensdauer kann deutlich begrenzt sein. Ebenso schwierig gestaltet sich das Temperaturmanagement der Komponenten. Ein Aufbau einer Vorrichtung zur Bebilderung von Druckplatten aus diskreten Bauelementen ermöglicht nur eine begrenzte minimale Baugröße. Das beschriebene Interleafrasterscanlinien-Verfahren ist für kompakte Laserlichtquellen ungeeignet, da die Distanz zwischen benachbarten Bildpunkten stets eine Einheit *p* größer als die Anzahl der Strahlen sein muss, sodass auf Schreibverfahren, in welchen Bildpunkte dicht nebeneinander gesetzt werden, zurückgegriffen werden muss.

Aufgabe der vorliegenden Erfindung ist es, eine Vorrichtung für die Bebilderung von Druckplatten mit einem Array von *n* Laserdioden vorzuschlagen, dessen emittiertes Licht eine gute Strahlqualität hat und welches einen kompakten Aufbau ermöglicht. Des Weiteren stellt sich die Aufgabe, ein verbessertes Interleafrasterscanlinien-Verfahren vorzuschlagen.

Diese Aufgabe wird erfindungsgemäß durch die Vorrichtung mit den Merkmalen gemäß Anspruch 1 und durch das Verfahren zur Bebilderung mit den Merkmalen gemäß Anspruch 16 gelöst.

Erfindungsgemäß weist die Vorrichtung zur Bebilderung von Druckplatten ein Array von *n* Einstreifenlaserdioden auf. Jede Einstreifenlaserdiode kann einzeln angesteuert werden. Die *n* Laserstrahlen können bevorzugt mit Lichtleitmitteln, wie Linsen, Spiegeln, optischen Fasern oder dergleichen, auf das Medium abgebildet werden. Die vermittels einer Abbildungsoptik erzeugten *n* Bildpunkte sind vorteilhafterweise auf einer Linie angeordnet und weisen einen Abstand *l* zwischen benachbarten Punkten auf. Im allgemeinen ist es jedoch nur erforderlich, dass die auf eine vorgegebene Linie in der Fläche der Druckplatte projizierten *n* Bildpunkte einen konstanten Abstand *l* aufweisen. Es findet eine Relativbewegung zwischen Medium und Bildpunkten in beiden, von der Fläche des Mediums aufgespannte Richtungen, statt. Neben der Bewegung, welche zur Verschiebung der Bildpunkte mit einer Translationskomponente senkrecht zu der durch die Linie der *n* Bildpunkte oder durch die vorgegebenen Linie, auf den die projizierten *n* Bildpunkte einen konstanten Abstand *l* aufweisen, definierte Richtung aufweist, findet eine Verschiebung parallel zur durch die Linie der *n* Bildpunkte oder durch die vorgegebenen Linie, auf den die projizierten *n* Bildpunkte einen konstanten Abstand *l* aufweisen, definierte Richtung statt. Der Betrag dieser Verschiebung ist vorteilhafterweise größer als der oder gleich dem Abstand *l* der *n* Bildpunkte. Es werden Rasterscanlinien erzeugt, welche einen Abstand *p* der Druckpunkte aufweisen, wobei der Abstand *p* der Druckpunkte kleiner als der Abstand *l* der Bildpunkte ist.

In einer bevorzugten Ausführungsform erfolgt die Stromversorgung des Arrays der Laserdioden mit einer Leistungsregelung. Vorteilhafterweise wird die Funktionstüchtigkeit bzw. ein möglicher Ausfall einer Einstreifenlaserdiode über ein entsprechendes Detektorelement entweder auf der Auskoppelseite der Laserdiode oder aber an einem anderen Resonatorspiegel überprüft. Das Detektorelement kann dabei sowohl eine Detektorzeile als auch ein einzelner Detektor sein, welcher die einzelnen Einstreifenlaserdioden abtastet.

Durch die Verwendung eines Arrays aus *n* Einstreifenlaserdioden, welche einzeln angesteuert werden können, und durch das zugehörige Interleafrasterscanlinien-Verfahren zur Bebilderung von Druckplatten ergeben sich eine Reihe von Vorteilen. Durch die Verwendung von Einstreifenlaserdioden wird eine gute Strahlqualität erreicht. Typischerweise hat die Beugungsmaßzahl M² einen Wert etwas über eins. In einem kompakten Aufbau kann ein hoher Integrationsgrad erreicht werden: Strahlungsquelle, Modulation und Regelung können in einem Bauteil vereint werden. Dadurch gibt es weniger optische und damit Justage empfindliche Komponenten. Die Lebensdauer des Bauteils ist im Wesentlichen nur durch die Lebensdauer des Lasers begrenzt. Durch den kompakten, modularen Aufbau ist das System skalierbar. Eine hohe Leistungsstabilität ist durch eine schnelle Regelung gewährleistet. Aufgrund des hohen Integrationsgrades lässt sich ein einfacheres Temperaturmanagement erreichen, weil nur dieses eine Bauteil gekühlt werden muss. Aufgrund der niedrigen Beugungsmaßzahl M² wird eine maximal mögliche Tiefenschärfe bei Fokussierung erreicht.

Weitere Vorteile und vorteilhafte Ausführungsformen der Erfindung werden anhand der nachfolgenden Figuren sowie deren Beschreibungen dargestellt.

Es zeigen im einzelnen:
- Figur 1: schematische Ansicht der typischen Geometrie der Bebilderung einer Druckplatte durch ein Array von Laserdioden mit *n* Laserstrahlen
- Figur 2: schematische Ansicht der Bebilderung einer Druckplatte auf einem Zylinder durch ein Array aus *n* Laserstrahlen
- Figur 3: Beispiel der Bebilderung mit einem Array aus fünf Bildpunkten im Interleafrasterscanlinien-Verfahren

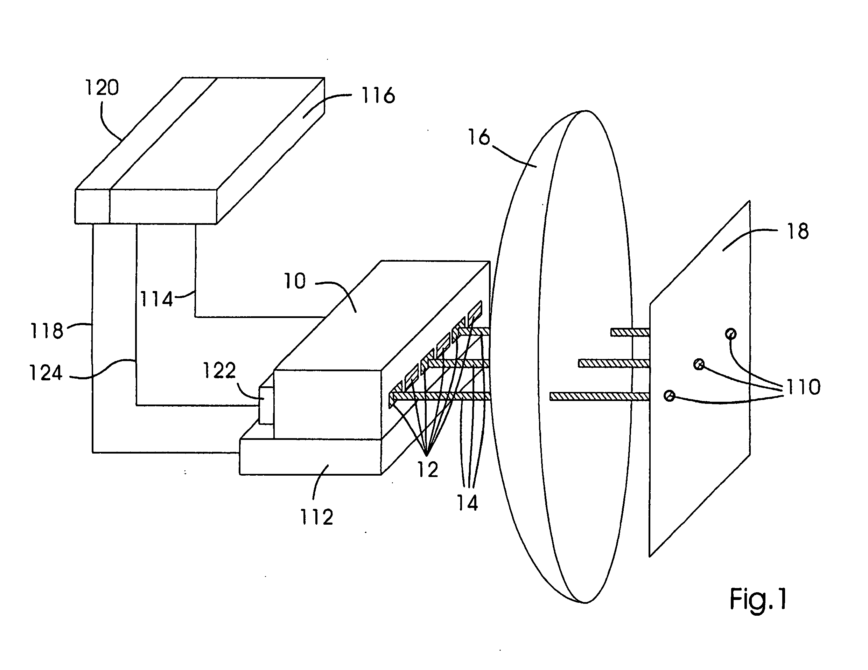

Die Figur 1 zeigt eine typische Geometrie zur Projektion von *n* Laserlichtstrahlen, welche von einem Array von *n* Laserdioden ausgehen. Die Lichtquelle 10 besteht aus einem einzeln ansteuerbaren Array von *n* Einstreifenlaserdioden 12. Typischerweise weist eine derartige Lichtquelle bis zu 100 Einstreifenlaserdioden, vorteilhafterweise zwischen 10 und 60, auf. Die Einstreifenlaserdioden besitzen Emitterflächen, welche typischerweise 1 x 5 Mikrometer² groß sind, und emittieren Laserstrahlung in vorteilhafter Strahlqualität, mit niedriger Beugungsmaßzahl M². Der Abstand einzelner Laserdioden auf dem Array liegt typischerweise zwischen 100 und 1000 Mikrometern. Vermittels der Abbildungsoptik 16 werden die *n* Laserstrahlen auf die *n* Bildpunkte 110 auf einer Platte 18 abgebildet. Vorteilhafterweise befindet sich die Druckplatte 18 in den Foki der Laserstrahlen 14. Es ist besonders vorteilhaft, dass durch die Abbildungsoptik 16 die Laserstrahlen sowohl in ihrem Durchmesserverhältnis (senkrecht und parallel zur durch die *n* Punkte definierte Achse) verändert als auch dass der Abstand der Bildpunkte zueinander korrigiert wird. Mit anderen Worten sowohl die Fleckgröße der *n* Bildpunke 110 als auch deren Lage zueinander und deren Abstand sind einstellbar. In der Regel ist der Abstand zwischen den einzelnen Laserdioden konstant, für eine vorteilhafte Bebilderung ist es aber zumindest erforderlich, dass nur der Abstand *l* der *n* Bildpunkte 110 konstant ist. Der Abstand *l* der *n* Bildpunkte isst größer als der Abstand *p* der Druckpunkte.

Die Lichtquelle 10 kann im kontinuierlichen Betrieb eingesetzt werden. Zur Erzeugung einzelner Lichtpakete wird die Laseremission für ein gewisses Zeitintervall entsprechend unterdrückt. In einer besonderen Ausführungsform ist es aber auch möglich, eine Lichtquelle 10, welche gepulste Strahlung emittiert, einzusetzen. Bei gepulster Strahlung muss die Repetitionsrate der Lichtimpulse mindestens genauso groß wie die Taktfrequenz zur Erzeugung der einzelnen Druckpunkte sein, sodass wenigstens ein Laserpuls für einen Druckpunkt zur Verfügung steht. Die Abbildungsoptik 16 kann sowohl reflektierende, transmittierende, refraktive oder ähnliche optische Komponenten aufweisen. Bevorzugt handelt es sich dabei um mikrooptische Komponenten. Die Abbildungsoptik 16 kann sowohl eine vergrößernde wie auch verkleinernde als auch in den beiden Richtungen parallel und senkrecht zur aktiven Zone der Laser unterschiedliche Abbildungsmaßstäbe besitzen, welches insbesondere vorteilhaft zur Divergenz- und Aberrationskorrektur ist. Die Oberfläche der Druckplatte 18 wird in ihren physikalischen oder chemischen Eigenschaften durch die Laserstrahlung verändert. Vorteilhafterweise kommen Druckplatten zum Einsatz, welche löschbar oder wiederbeschreibbar sind.

In bevorzugter Ausführungsform befindet sich die Lichtquelle 10 auf einem Kühlelement 112. Die Lichtquelle 10 ist vermittels einer Leitung zur Stromversorgung und Steuerung 114 mit der Steuerungseinheit 116 verbunden. Die Steuerungseinheit 116 weist einzelne Komponenten auf, mit denen es möglich ist, die einzelnen Laserdioden des Arrays getrennt voneinander anzusteuern oder zu regeln. Vermittels einer Leitung zur Steuerung des Kühlelementes 118 ist das Kühlelement 112 mit der Temperaturregelung 120 verbunden.

Zur Funktionsüberprüfung und Bestimmung der Ausgangsleistung der einzelnen Laserdioden 12 ist ein Detektor 122 vorgesehen. Der Detektor kann dabei derart ausgeführt sein, dass für jede Laserdiode eine einzelne Messeinrichtung vorgesehen ist oder aber dass eine Messeinrichtung die einzelnen Laserdioden im Wechsel oder nach Bedarf überprüft. Vorteilhafterweise ist der Detektor 122 mit der Steuerungseinheit 116 über die Verbindung 124 verknüpft, damit die Ausgangsleistung als ein Parameter unter anderen zur Generierung eines Regelsignals in der Lasersteuerung 116 verarbeitet wird.

Eine derartige erfindungsgemäße Einrichtung kann innerhalb oder außerhalb eines Druckwerkes oder einer Druckmaschine verwirklicht werden.

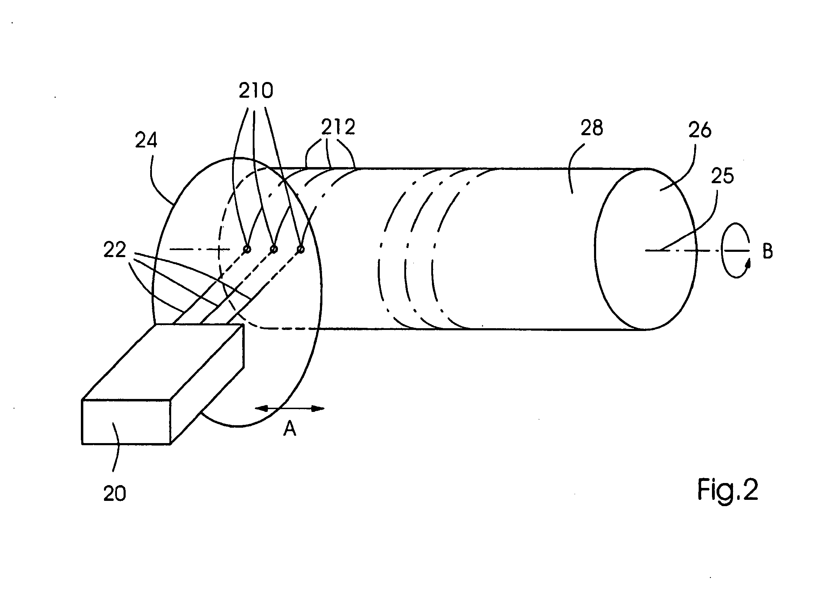

In der Figur 2 wird die Bebilderung einer Druckplatte, welche sich auf einem rotierbaren Zylinder befindet, gezeigt. Die Lichtquelle 20 erzeugt *n* Laserstrahlen 22, welche vermittels der Abbildungsoptik 24 auf *n* Bildpunkte 210 abgebildet werden. Vorteilhafterweise haben die *n* Bildpunkte einen gleichmäßigen Abstand und liegen auf einer Achse. Die Druckplatte 28 befindet sich auf einem Zylinder 26, welcher um seine Symmetrieachse 25 drehbar ist. Diese Drehung ist durch den Pfeil B bezeichnet. Die Lichtquelle 20 kann parallel zur Symmetrieachse 25 des Zylinders auf linearem Wege bewegt werden, welches mit dem Doppelpfeil A gekennzeichnet ist. Zur kontinuierlichen Bebilderung rotiert der Zylinder 26 mit der Druckplatte 28 gemäß der Rotationsbewegung B, und die Lichtquelle translatiert längs des Zylinders gemäß der Bewegungsrichtung A. Die Vorschubgeschwindigkeit wird durch die Anzahl der Laserstrahlen 22 die Breite *p* eines Druckpunktes bestimmt. Es ergibt sich eine Bebilderung, welche auf schraubenförmigem Wege die Symmetrieachse 25 des Zylinders 26 umläuft. Der Weg der Bildpunkte 210 ist durch die Linien 212 angedeutet. Mit anderen Worten nach erfolgter Bebilderung von *n* Punkten erfolgt eine relative Verschiebung von Druckplatte 28 und Bildpunkten 210 mit einer Vektorkomponente senkrecht zu der durch die Linie der *n* Bildpunkte definierten Richtung um einen ersten bestimmten Betrag, sodass an einer anderen Stelle der Druckplatte 28 erneut *n* Punkte geschrieben werden. Dadurch entstehen sogenannte Rasterscanlinien von Bildpunkten. Zu jedem bestimmten Abstand benachbarter Rasterscanlinien und Anzahl *n* der Bildpunkte ergibt sich ein zweiter bestimmter Betrag einer notwendigen Verschiebung parallel zu der durch die Linie der *n* Bildpunkte definierten Achse, sodass eine kontinuierliche Bebilderung, d. h. die Bebilderung jedes vorgesehenen Rasterpunktes auf der Druckplatte 28, mit dem Interleafrasterscanlinien-Verfahren möglich ist.

In einem alternativen Ausführungsbeispiel können die Bildpunkte 210 auch meanderförmig über die Druckplatte 28 bewegt werden, indem zunächst eine vollständige Bebilderung entlang einer Linie parallel zur Symmetrieachse 25 des Zylinders 26 und anschließend eine schrittweise Rotation um die Symmetrieachse 25 des Zylinders 26 ausgeführt wird.

Es ist klar, dass es nur auf eine relative Bewegung zwischen den Bildpunkten 210 und der Druckplatte 28 ankommt. Diese Relativbewegung kann auch durch eine Bewegung des Druckzylinders 26 erreicht werden. Für beide Bewegungsrichtungen der Translation A und der Rotation B gilt, dass die Bewegungen kontinuierlich oder schrittweise erfolgen können.

Des Weiteren kann in einem alternativen Ausführungsbeispiel die Vorrichtung zur Bebilderung von Druckplatten, die Lichtquelle 20, die Abbildungsoptik 24 und dergleichen aufweisend, auch innerhalb des Druckzylinders 26 ausgeführt sein, sodass eine platzsparende Anordnung erreicht wird.

Bevor das Interleafrasterscanlinien-Verfahren anhand einer Figur näher beschrieben wird, sind allgemeine Erklärungen dazu notwendig. Wie bereits erwähnt, werden zur Bebilderung einer Druckplatte die Bildpunkte über die Druckfläche zunächst mit einer Komponente senkrecht zu der durch die Linie der Bildpunkte definierten Richtung verschoben, sodass sogenannte Rasterscanlinien entstehen. Unter einer zusammenhängenden Zeile von Druckpunkten versteht man dann eine Linie, welche durch die anschließende Verschiebung in der durch die Richtung der Druckpunkte definierten Richtung entsteht. Mit anderen Worten auf gleicher Höhe liegende Druckpunkte verschiedener, nebeneinander geschriebener Scanlinien.

Die Abstände der *n* Bildpunkte, welche durch die einzelnen *n* Laserdioden gleichzeitig erzeugt werden, sind konstant gewählt, vorteilhafterweise ist die Länge zwischen zwei benachbarten Bildpunkten *l* ein ganzzahliges Vielfaches *m* des Abstandes *p* der Druckpunkte, mit anderen Worten *l = m* x *p* . Eine durchgehende Beschriftung, d. h. jeder Rasterpunkt wird zumindest einmal vom Bildpunkt eines Lasers berührt, mit *n* gleichzeitig geschriebenen Bildpunkten im Abstand *l = m x p*, wobei *m* eine natürliche Zahl und *p* den Abstand der Druckpunkte bezeichnen, ist immer möglich, wenn man eine passende Verschiebung wählt. Die Weite der Verschiebung ist vorteilhafterweise gleich der Anzahl der Bildpunkte.

Es kann dabei jedoch geschehen, dass ein Punkt mehrfach beschriftet wird. Eine durchgehende Beschriftung, mit anderen Worten jeder Druckpunkt wird genau einmal geschrieben, ist insbesondere dann möglich, wenn die Anzahl der Bildpunkte *n* und ihr Abstand *l*, gemessen in Einheiten des Abstandes *p* der Druckpunkte, keinen gemeinsamen Teiler haben. Anders ausgedrückt, *n* und *m* sind teilerfremd. Dieses ist beispielsweise dann der Fall, wenn *m* und *n* unterschiedliche Primzahlen sind. Gleichzeitig ist dann die Verschiebung, welche durch die durch die *n* Bildpunkte definierte Linie gegebene Richtung festgelegt ist, als *n* zu wählen. Dabei entsteht am Anfang und am Ende der zu schreibenden Zeile ein Rand von der Größe r: *r = n x m -* (*n + m -* 1).

Da die einzelnen Laserdioden einzeln ansteuerbar sind, ist es möglich, jeden Druckpunkt individuell zu gestalten. Die Leistung eines bestimmten Laserstrahls, welcher zur Beschriftung eines Rasterpunktes vorgesehen ist, wird entsprechend der gegebenen Bilddateninformation festgelegt. Damit kann eine individuelle Schwärzung verschiedener Druckpunkte erreicht werden.

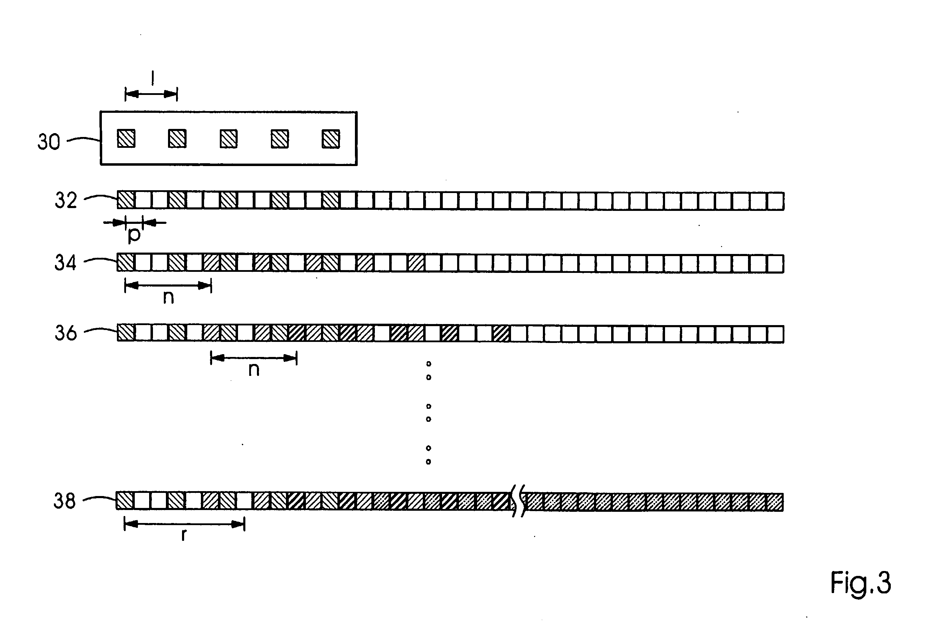

Die Figur 3 illustriert das Interleafrasterscanlinien-Verfahren zum Beschriften von Druckplatten anhand eines Beispiels von fünf Bildpunkten, welche durch die simultane Bestrahlung mit fünf einzelnen Laserdioden gleichzeitig erzeugt werden. Druckpunkte werden in dieser Figur vereinfacht als Kästchen dargestellt. Jeder Druckpunkt muss, wie bereits erwähnt, zumindest einmal von einem Bildpunkt eines Lasers berührt werden, damit er entsprechend den gegebenen Bilddaten belichtet werden oder unverändert gelassen werden kann. Eine zusammenhängende Zeile, welche zu schreiben ist, besteht in diesem Beispiel aus lückenlos aneinander gereihten Druckpunkten. Deren Abstand ist durch *p* bezeichnet. In der Figur 3 besteht die Gruppe von gleichzeitig geschriebenen Druckpunkten 30 aus fünf Bildpunkten, welche einen gleichmäßigen Abstand *l* aufweisen. In der ersten Bebilderung 32 werden fünf Einheitspunkte mit dem Abstand *l* = 3*p* geschrieben. Es folgt eine Verschiebung der Gruppe von gleichzeitig erzeugten Druckpunkten 30 um fünf Einheitspunkte, da in diesem Beispiel fünf Druckpunkte gleichzeitig geschrieben werden in die durch die Achse der Druckpunkte definierten Richtung, hier beispielsweise nach rechts. Im zweiten Bebilderungsschritt 34 werden wieder fünf Bildpunkte gesetzt. In Iteration erfolgt eine erneute Verschiebung um fünf Einheitspunkte in die durch die Achse der Druckpunkte definierten Richtung, hier beispielsweise nach rechts. Im folgenden Bebilderungsschritt 36 werden erneut fünf Punkte gesetzt. Aus dieser Sequenz ist ersichtlich, dass die Druckplatte lückenlos beschriftet werden kann: Jeder durch ein Kästchen dargestellte Druckpunkt wird einmal vom Bildpunkt eines Lasers berührt. In jeder erneuten Bebilderung nach einem Verschiebungsschritt um fünf Längeneinheiten, gemessen in Einheiten von *p* nach rechts wird stets dasselbe Muster an bereits beschriebenen und noch unbeschriebenen Druckpunkten erzeugt, wie es in 38 ersichtlich ist. Mit anderen Worten, die Zeile von geschriebenen Bildpunkten weist an ihrem rechten Ende noch gewisse Lücken mit unbeschriebenen Rasterpunkten auf. Erfolgt nun eine weitere Bebilderung von fünf Rasterpunkten am rechten Ende, so entsteht dieselbe Abfolge von noch unbeschrifteten und bereits beschrifteten Rasterpunkten. Gleichzeitig wird der Anteil der vollständig beschrifteten Druckpunkte der Zeile immer länger. In 38 ist ebenfalls der Rand von der Größe *r*, in diesem Fall 8 Druckpunkten, gemessen in Einheiten des Abstand *p* der Druckpunkte, ersichtlich.

Auch bei Ausfall einzelner Einstreifenlaserdioden im Array ist es möglich, das vorgeschlagene Interleafrasterscanlinien-Verfahren zum Beschreiben zu verwenden. Insbesondere dann, wenn die Anzahl der *n* Bildpunkte der Laserstrahlen und der Abstand zweier benachbarter Bildpunkte *l*, gemessen in Einheiten von *p*, teilerfremd sind, ist die Bebilderungsgeschwindigkeit maximal. Mit anderen Worten, es ist möglich, eine Schrittweite anzugeben, sodass jeder zu schreibende Punkt nur einmal von einem Bildpunkt der Laserstrahlen berührt wird.

Für den Fall der Funktionsuntüchtigkeit eines oder mehrerer Einstreifenlaserdioden in der Gruppe der gleichzeitig geschriebenen Bildpunkte 30 ist eine Beschriftung mit Hilfe des Interleafrasterscanlinien-Verfahrens immer noch möglich. Dabei wird immer das größte, im gleichen Abstand benachbarte Bildpunkte aufweisende Teilstück der Gruppe zum Beschriften verwendet. Offensichtlich muss dann auch, um eine durchgehende Beschriftung zu erreichen, die Schrittweite reduziert werden. Vorteilhafterweise geschieht das nach den oben aufgestellten Regeln hinsichtlich der Eigenschaften natürlicher Zahlen.

Die Bebilderung einer Druckplatte mit dem Interleafrasterscanlinien-Verfahren ist bei jeder Kombination von Abständen zwischen den benachbarten Bildpunkten *l* und deren Anzahl *n* möglich. Um eine durchgehende Beschriftung der Druckplatte zu erreichen, sind jedoch geeignete Parameter zu wählen. Bei Ausfall eines Bildpunktes ist eine Bebilderung mit reduzierter Geschwindigkeit möglich.

Für das beschriebene Interleafrasterscanlinien-Verfahren zum Beschreiben einer Druckplatte wird eine Vielzahl von Laserstrahlen benötigt. Diese können auch aus anderen Laserlichtquellen als die vorteilhafterweise einzusetzenden Laserdioden erzeugt werden. Um den projizierten Abstand zwischen den einzelnen Lichtquellen zu verändern, kann in einer vorteilhaften Weiterbildung die Druckplatte gegenüber der senkrecht zu den *n* Laserstrahlen liegenden Ebene um einen von null verschiedenen Winkel verkippt sein.

Eine weitere vorteilhafte Weiterbildung der Erfindung weist ein zweidimensionales Array von *n*₁ × *n*₂ Bildpunkten auf. In entsprechender Verallgemeinerung von einer auf zwei Dimensionen ist vorgesehen, dass die Abstände *l₁* und *l₂* zwischen benachbarten Punkten in den zwei Richtungen senkrecht zueinander jeweils konstant sind, sodass eine parallele Verarbeitung von *n₂* Linien im Abstand *l₂* nach dem angesprochenen eindimensionalen Interleafrasterscanlinien-Verfahren mit *n₁* Bildpunkten im Abstand *l₁* erfolgen kann. In senkrechter Richtung wird dann ebenfalls eine Verschiebung gemäß der für das Interleafrasterscanlinien-Verfahren aufgestellten Regeln durchgeführt, um Druckpunkte dicht zu setzen.

### Bezugszeichenliste

- 10: Lichtquelle, einzeln ansteuerbares Laserdiodenarray
- 12: Einstreifenlaserdioden
- 14: Lichtstrahl
- 16: Abbildungsoptik
- 18: Druckplatte
- 110: Bildpunkt
- 112: Kühlelement
- 114: Leitung zur Stromversorgung und Steuerung
- 116: Steuerungseinheit
- 118: Leitung zur Temperaturregelung
- 120: Temperaturregelung
- 122: Detektor zur Funktionsüberprüfung und Leistungsmessung
- 124: Verbindung zur Steuerung
- 20: Lichtquelle
- 22: Laserstrahlen
- 24: Abbildungsoptik
- 25: Symmetrieachse
- 26: Zylinder
- 28: Druckplatte
- 210: Bildpunkte
- 212: Weg der Bildpunkte
- A: Translation
- B: Rotation
- 30: Gruppe von gleichzeitig geschriebenen Druckpunkten
- 32: erste Bebilderung
- 34: zweite Bebilderung
- 36: dritte Bebilderung
- 38: iterierte Bebilderung
- *l*: Abstand der Bildpunkte
- *p*: Abstand der Druckpunkte
- *n*: Anzahl der Bildpunkte
- *r*: Rand

## Patentansprüche

1. Vorrichtung zur Bebilderung von Druckplatten (18,28) mit einer Lichtquelle (10,20) mit *n* Laserdioden (12), welche auf *n* Bildpunkte (110,210) abgebildet werden, sodass jedem i-ten Punkt mit *i* aus {1, ..., *n*} jeweils eine Laserdiode (12) zugeordnet ist, wobei die *n* Bildpunkte (110,210) durch einen Abstand benachbarter Punkte *1* getrennt sind und ein Abstand *p* benachbarter Druckpunkte vorgesehen ist, wobei der Abstand *1* benachbarter Bildpunkte (110,210), gemessen in Einheiten des Abstandes *p* der Druckpunkte, ein ganzzahliges Vielfaches *m* des Abstandes *p* benachbarter Druckpunkte ist,
**dadurch gekennzeichnet,**
**dass** die Lichtquelle (10,20) ein einzeln ansteuerbares Laserdiodenarray von Einstreifenlaserdioden (12) ist.

2. Vorrichtung zur Bebilderung von Druckplatten (18,28) gemäß einem der oberen Ansprüche,
**dadurch gekennzeichnet,**
**dass** das ganzzahlige Vielfache in teilerfremd zur Anzahl *n* der Bildpunkte (110,210) ist.

3. Vorrichtung zur Bebilderung von Druckplatten (18,28) gemäß einem der oberen Ansprüche,
**dadurch gekennzeichnet,**
**dass** der Abstand *1* benachbarter Bildpunkte (110,210), gemessen in Einheiten des Abstandes *p* benachbarter Druckpunkte, kleiner als deren Anzahl *n* ist.

4. Vorrichtung zur Bebilderung von Druckplatten (18,28) gemäß einem der oberen Ansprüche
**dadurch gekennzeichnet,**
**dass** das Vielfache *m* und die Anzahl *n* der Bildpunkte (110,210) Primzahlen sind.

5. Vorrichtung zur Bebilderung von Druckplatten (18,28) gemäß einem der oberen Ansprüche,
**dadurch gekennzeichnet**
**dass** die Vorrichtung eine Abbildungsoptik (16,24) zur Divergenz- und/oder Aberrationskorrektur aufweist.

6. Vorrichtung zur Bebilderung von Druckplatten (18,28) gemäß einem der oberen Ansprüche,
**dadurch gekennzeichnet,**
**dass** wenigstens eine der Laserdioden (12) des Arrays (10,20) eine Regelung vermittels einer Stcuerungseinheit (116) aufweist.

7. Vorrichtung zur Bebilderung von Druckplatten (18,28) gemäß einem der oberen Ansprüche,
**dadurch gekennzeichnet,**
**dass** die Anzahl der Laserdioden (12) im Array (10,20) zwischen 10 und 100 liegt.

8. Vorrichtung zur Bebilderung von Druckplatten (18,28) gemäß einem der oberen Ansprüche,
**dadurch gekennzeichnet,**
**dass** der Abstand der Laserdioden (12) auf dem Array (10,20) zwischen 100 Mikrometer und 1000 Mikrometer beträgt und die Breite der Emitterflächen unter 10 Mikrometern, typischerweise 5 Mikrometer, liegt.

9. Vorrichtung zur Bebilderung von Druckplatten (18,28) gemäß einem der oberen Ansprüche,
**dadurch gekennzeichnet,**
**dass** wenigstens ein Detektor (122) zur Überprüfung der Funktionstüchtigkeit und Bestimmung der Ausgangsleistung einer oder mehrerer Laserdioden (12) vorgesehen ist.

10. Vorrichtung zur Bebilderung von Druckplatten (18,28) gemäß Anspruch 9,
**dadurch gekennzeichnet,**
**dass** die mit dem Detektor (122) bestimmte Ausgangsleistung der Laserdioden (12) zur Generierung eines Regelsignals in der Lasersteuerung (116) verarbeitet wird.

11. Vorrichtung zur Bebilderung von Druckplatten (18,28) gemäß einem der oberen Ansprüche,
**dadurch gekennzeichnet,**
**dass** wenigstens eine Laserdiode (12) Strahlung im Pulsbetrieb emittiert.

12. Vorrichtung zur Bebilderung von Druckplatten (18,28) gemäß Anspruch 11,
**dadurch gekennzeichnet,**
das die Repetitionsfrequenz der Lichtimpulse mindestens genauso groß wie die Taktfrequenz zur Verschiebung der einzelnen Druckpunkte ist.

13. Vorrichtung zur Bebilderung von Druckplatten (18,28) gemäß einem der oberen Ansprüche,
**dadurch gekennzeichnet,**
**dass** die Vorrichtung eine Abbildungsoptik (16,24) aufweist, welche wenigstens ein reflektives optisches Element umfasst.

14. Vorrichtung zur Bebilderung von Druckplatten (18,28) gemäß einem der oberen Ansprüche,
**dadurch gekennzeichnet,**
**dass** die Vorrichtung eine Abbildungsoptik (16,24) mit mikrooptischen Komponenten aufweist.

15. Vorrichtung zur Bebilderung von Druckplatten (18,28) gemäß einem der oberen Ansprüche,
**dadurch gekennzeichnet,**
**dass** die Druckplatte (18,28) löschbar oder wiederbeschreibbar ist.

16. Verfahren zurBebilderung von Druckplatten (18,28) durch Erzeugung von , Druckpunkten mit einer Lichtquelle (10,20) mit *n* Laserdioden (12), welche mit einer Abbildungsoptik (16,24) auf n Bildpunkte (110,210), die auf einer Linie angeordnet sind, auf eine auf einem Zylinder (26) aufgenommene Druckplatte (18,28) abgebildet werden, wobei die *n* Bildpunkte (110,210) durch einen Abstand benachbarter Punkte *1* getrennt sind, mit den Verfahrensschritten:
- gleichzeitige Erzeugung von *n* Bildpunkten (110,210) auf der Druckplatte (18,28) in jedem Bebilderungsschritt, und
- Erzeugung einer Relativbewegung zwischen den *n* Bildpunkten (110,210) und der Druckplatte (18,28),
- Verschiebung der *n* Bildpunkte (110,210) durch Rotation (B) des die Druckplatte (18,28) aufnehmenden Zylinders (26) senkrecht zur durch die Linie der *n* Bildpunkte (110, 210) definierten Richtung um einen ersten bestimmten Betrag pro Bebilderungsschritt,
- Verschiebung der *n* Bildpunkte durch Translation (A) des Arrays (10,20) von *n* Laserlichtquellen in der durch die *n* Bildpunkte (110,210) definierten Richtung parallel zur Symmetrieachse (25) des Zylinders (26) um einen zweiten bestimmten Betrag, der größer als der Abstand *l* benachbarter Bildpunkte ist, pro Umdrehung des Zylinders (26),
**gekennzeichnet durch :**
- Verwendung einer Vorrichtung zur Bebilderung von Druckplatten (18,28) mit einer Lichtquelle (10) mit *n* Laserdioden (12) gemäß einem der oberen Ansprüche zur gleichzeitigen Erzeugung der *n* Bildpunkte (110,210),
- Gleichzeitige Durchführung der besagten Verschiebungen derart, dass die Bildpunkte (110,210) die Symmetrieachse (25) des Zylinders (26) auf schraubenförmigem Wege (212) in interleafrastei-scanlinien umlaufen.

17. Verfahren zur Bebilderung von Druckplatten (18,28) gemäß Anspruch 16,
**dadurch gekennzeichnet,**
**dass** die Verschiebung in der durch die *n* Bildpunkte (110,210) definierten Richtung, gemessen in Einheiten des Abstandes *p* der Druckpunkte, gleich der Anzahl *n* der Bildpunkte (110,210) ist.

18. Verfahren zur Bebilderung von Druckplatten (18,28) gemäß Anspruch 17,
**dadurch gekennzeichnet,**
**dass** der Abstand *l* der Bildpunkte (110,210) ein ganzzahliges Vielfaches des Abstandes *p* der Druckpunkte der Laserdioden (12) ist.

19. Verfahren zur Bebilderung von Druckplatten (18,28) gemäß einem der Ansprüche 16 bis 18,
**dadurch gekennzeichnet,**
**dass** der Abstand *1* der Bildpunkte (110, 210), gemessen in Einheiten des Abstandes *p* der Druckpunkte, und die Anzahl der Laserdioden (12) *n* teilerfremd sind.

20. Verfahren zur Bebilderung von Druckplatten (18,28) gemäß Anspruch 19,
**dadurch gekennzeichnet,**
**dass** der Abstand *1* der Bildpunkte (110, 210), gemessen in Einheiten des Abstandes *p* der Druckpunkte, und die Anzahl der Laserdioden (12) Primzahlen sind.

21. Druckwerk,
**dadurch gekennzeichnet,**
**dass** das Druckwerk wenigstens eine Vorrichtung zur Bebilderung von Druckplatten (18,28) gemäß einem der Ansprüche 1 bis 15 aufweist.

22. Druckmaschine,
**dadurch gekennzeichnet,**
**dass** die Druckmaschine wenigstens ein Druckwerk gemäß Anspruch 21 aufweist.

## Claims

1. A device for imaging printing plates (18, 28) comprising: a light source (10, 20) with *n* laser diodes (12) which image *n* image points (110, 210) so that one laser diode (12) is allocated to each i-th point with *i* being from {1, ..., *n*}, wherein the *n* image points (110, 210) are separated by a spatial interval between adjacent points *l* and a pitch distance p between adjacent dots is provided, wherein the spatial interval *l* between adjacent image points (110, 210), measured in units of the pitch distance *p* of dots is an integral multiple *m* of the pitch distance *p* between adjacent dots, **characterized in that** the light source (10, 20) is an individually controllable laser diode array of single-strip laser diodes (12).

2. The device for imaging printing plates (18, 28) in accordance with one of the above claims, **characterized in that** the integral multiple *m* and the number *n* of image points (110, 210) have no common denominator.

3. The device for imaging printing plates (18,28) in accordance with one of the above claims, **characterized in that** the spatial interval *l* between adjacent image points (110,210), measured in units of the pitch distance *p* between adjacent dots is smaller than the number *n* of the image points.

4. The device for imaging printing plates (18, 28) in accordance with one of the above claims, **characterized in that** the multiple *m* and the number *n* of image points (110, 210) are prime numbers.

5. The device for imaging printing plates (18, 28) in accordance with one of the above claims, **characterized in that** the device comprises an imaging optics (16, 24) for correcting at least one of divergence and aberration.

6. The device for imaging printing plates (18, 28) in accordance with one of the above claims, **characterized in that** at least one of the laser diodes (12) of the array (10, 20) comprises a control by means of a control unit (116).

7. The device for imaging printing plates (18, 28) in accordance with one of the above claims, **characterized in that** the number of laser diodes (12) in the array (10,20) is between 10 and 100.

8. The device for imaging printing plates (18, 28) in accordance with one of the above claims, **characterized in that** the laser diodes (12) are spaced apart on the array (10, 20) by a distance of between 100 micrometers and 1000 micrometers, and the width of the emitter surfaces is less than 10 micrometers, typically 5 micrometers.

9. The device for imaging printing plates (18, 28) in accordance with one of the above claims, **characterized in that** at least one detector (122) for testing for correct functioning and establishing the power output of one or a plurality of laser diodes (12) is provided.

10. The device for imaging printing plates (18, 28) in accordance with claim 9, **characterized in that** the power output of the laser diodes (12) established by the detector (122) is processed in the laser control unit (116) for generating a control signal.

11. The device for imaging printing plates (18, 28) in accordance with one of the above claims, **characterized in that** the radiation emitted by at least one laser diode (12) is pulsed.

12. The device for imaging printing plates (18, 28) in accordance with claim 11,
**characterized in that**
the repetition rate of the light pulses is at least exactly as great as the pulse frequency for displacing the individual dots.

13. The device for imaging printing plates (18, 28) in accordance with one of the above claims, **characterized in that** the device is provided with an imaging optics (16, 24) comprising at least one reflective optical element.

14. The device for imaging printing plates (18, 28) in accordance with one of the above claims, **characterized in that** the device is provided with an imaging optics (16, 24) having micro-optical components.

15. The device for imaging printing plates (18, 28) in accordance with one of the above claims, **characterized in that** the printing plate (18, 28) is erasable or rewritable.

16. A method for imaging printing plates (18, 28) by generating dots using a light source (10, 20) with *n* laser diodes (12) which use an imaging optics (16, 24) to image *n* image points (110, 210), arranged on a line, on a printing plate (18, 28) mounted on a cylinder (26), wherein the *n* image points (110,210) are separated by a spatial interval between adjacent points *1*, comprising the steps of:
- simultaneously generating *n* image points (110, 210) on the printing plates (18, 28) with every imaging step, and
- generating a relative motion between the *n* image points (110, 210) and the printing plate (18, 28)
- with every imaging step displacing the n image points (110,210) through the rotation (B) of the cylinder (26) holding the printing plate (18, 28) perpendicular to the direction defined by the line of the *n* image points (110,210) by a first specific amount,
- with every rotation of the cylinder (26) displacing the *n* image points through translation (A) of the array (10, 20) of *n* laser light sources in the direction defined by the *n* image points (110, 210) parallel to the symmetrical axis (25) of the cylinder (26) by a second specific amount which is greater than the spatial interval *1* between adjacent image points, **characterized by**:
- the use of a device for imaging printing plates (18, 28) using a light source (10) with *n* laser diodes (12) in accordance with one of the above claims for simultaneously generating *n* image points (110, 210),
- the simultaneous execution of said displacements such that the *n* image points (110,210) circulate around the symmetrical axis (25) of the cylinder (26) in a helical path (212) in interleaving raster scan lines.

17. The method for imaging printing plates (18,28) in accordance with claim 16, **characterized in that** the displacement in the direction defined by the *n* image points (110, 210), measured in units of the pitch distance p of dots, is equal to the number *n* of image points (110, 210).

18. The method for imaging printing plates (18, 28) in accordance with claim 17, **characterized in that** the spatial interval *l* between image points (110, 210) is an integral multiple of the pitch distance p of dots of the laser diodes (12).

19. The method for imaging printing plates (18,28) in accordance with one of the claims 16 to 18, **characterized in that** the spatial interval *1* between the image points (110, 210), measured in units of the pitch distance *p* of dots, and the number of laser diodes (12) n have no common denominator.

20. The method for imaging printing plates (18, 28) in accordance with claim 19, **characterized in that** the spatial interval *1* between the image points (110, 210), measured in units of the pitch distance *p* of dots, and the number of laser diodes (12) are prime numbers.

21. A printing unit, **characterized in that** the printing unit comprises at least one device for imaging printing plates (18, 28) in accordance with one of the claims 1 to 15.

22. A printing press, **characterized in that** the printing press comprises at least one printing unit in accordance with claim 21.

## Revendications

1. Dispositif d'illustration de plaques d'impression (18, 28) avec une source lumineuse (10, 20) avec *n* diodes laser (12) sur lesquelles sont reproduits *n* points d'image (110, 210) de sorte que chaque point i-nième avec *i* parmi {1,...,n} (110, 210) est associé respectivement à une diode laser (12), les n points d'image (110, 210) étant séparés par une distance de points voisins *1*, et une distance *p* de point voisins d'impression étant prévue, la distance *l* de points d'image voisins (110, 210) mesurée en unités de la distance p des points d'impression étant un multiple entier *m* de la distance *p* par des points d'impression voisins **caractérisé en ce que** la source de lumière (10, 20) est une matrice individuelle de diodes laser (12) commandables séparément.

2. Dispositif d'illustration de plaques d'impression (18, 28) selon l'une des revendications ci-dessus, **caractérisé en ce que** le multiple entier *m* représente des nombres premiers entre eux par rapport au nombre des points d'images (110, 210).

3. Dispositif d'illustration de plaques d'impression (18, 28) selon l'une des revendications ci-dessus, **caractérisé en ce que** la distance *1* de points d'images voisins (110, 210) mesurée en unités de la distance *p* de points d'impression voisins, est plus petit que leur nombre.

4. Dispositif d'illustration de plaques d'impression (18, 28) selon l'une des revendications ci-dessus, **caractérisé en ce que** le multiple m et le nombre n des point d'image (110, 210) sont des *n* nombres premiers.

5. Dispositif d'illustration de plaques d'impression (18, 28) selon l'une des revendications ci-dessus, **caractérisé en ce que** le dispositif présente une optique de reproduction (16, 24) pour la correction de divergence et/ou d'aberration.

6. Dispositif d'illustration de plaques d'impression (18, 28) selon l'une des revendications ci-dessus, **caractérisé en ce qu'**au moins l'une des lasers diodes (12) de la matrice (10, 20) présente un réglage au moyen d'une unité de commande.

7. Dispositif d'illustration de plaques d'impression (18, 28) selon l'une des revendications ci-dessus, **caractérisé en ce que** le nombre des diodes laser (12) de la matrice (10, 20) est compris entre 10 et 100.

8. Dispositif d'illustration de plaques d'impression (18, 28) selon l'une des revendications ci-dessus, **caractérisé en ce que** l'écart des diodes laser (12) s'élève sur la matrice (10, 20) entre 100 micromètres et 10000 micromètres et la largeur des surfaces émettrices est inférieure à 10 micromètres, typiquement 5 micromètres.

9. Dispositif d'illustration de plaques d'impression (18, 28) selon l'une des revendications ci-dessus, **caractérisé en ce qu'**au moins un détecteur (122) est prévu pour la vérification de la fonctionnalité et la destination de la puissance de sortie d'une ou de plusieurs diodes laser (12).

10. Dispositif d'illustration de plaques d'impression (18, 28) selon la revendication 10,
**caractérisé en ce que** la puissance de sortie déterminée par le détecteur (122) des diodes laser (12) est traitée pour la génération d'un signal de réglage dans la commande laser (116).

11. Dispositif d'illustration de plaques d'impression (18, 28) selon l'une des revendications ci-dessus, **caractérisé en ce qu'**au moins une diode laser (12) émet un rayonnement en mode d'impulsion.

12. Dispositif d'illustration de plaques d'impression (18, 28) selon la revendication 11, **caractérisé en ce que** la fréquence de répétition des impulsions lumineuses est au moins égale à la fréquence de rythme pour le déplacement des différents points d'impression.

13. Dispositif d'illustration de plaques d'impression (18, 28) selon l'une des revendications ci-dessus, **caractérisé en ce que** le dispositif présente une optique de reproduction (16, 24) qui comprend au moins un élément optique réflecteur.

14. Dispositif d'illustration de plaques d'impression (18, 28) selon l'une des revendications ci-dessus, **caractérisé en ce que** le dispositif présente une optique de reproduction (16, 24) avec des composants micro-optiques.

15. Dispositif d'illustration de plaques d'impression (18, 28) selon l'une des revendications ci-dessus, **caractérisé en ce que** la plaque d'impression (18, 28) peut être effacée et est réinscriptible.

16. Procédé d'illustration de plaques d'impression (18, 28) par génération de points d'impression avec une source de lumière (10, 20) munis de *n* diodes laser (12) qui sont reproduits avec une optique de reproduction (16, 24) sur n points d'image (110, 210) disposés sur une ligne, sur une plaque d'impression (18, 28) réceptionné sur un cylindre (26), les *n* points d'image (110, 210) étant séparés par une distance de points voisins *1*,
avec les étapes de procédé suivantes:
- génération simultanée de *n* points d'images (110, 210) sur la plaque d'impression (18, 28) dans chaque étape d'illustration, et
- génération d'un mouvement relatif entre les n points d'images (110, 210) et la plaque d'impression (18, 28),
- déplacement des *n* points d'image (110, 210) par rotation (B) du cylindre (26) recevant la plaque d'impression (18, 28) perpendiculairement à la direction définie par la ligne de la distance des *n* points d'images (110, 210) d'un premier montant défini pour chaque étape d'illustration,
- déplacement des *n* points d'image par translation (A) de la matrice (10, 20) de *n* sources laser dans la direction définie par les *n* points d'image (110, 210) parallèlement à l'axe de symétrie (25) du cylindre (26) de l'équivalent d'un second montant défini supérieur à la distance de *1* points d'image voisins, par rotation du cylindre (26),
**caractérisé par**
- l'utilisation d'un dispositif pour l'illustration de plaques d'impression (18, 28) avec une source de lumière (10) munie de *n* diodes laser (12) selon l'une des revendications ci-dessus pour la génération simultanée des *n* points d'image (110, 210)
- la mise en oeuvre simultanée des dits déplacements de sorte que les *n* points d'image (110, 210) contournent l'axe de symétrie (25) du cylindre (26) sur des parcours hélicoïdales dans des lignes de balayage de trame de feuillet intercalé (interleaf).

17. Procédé pour l'illustration de plaques d'impression (18, 28) selon la revendication 16, **caractérisé en ce que** le déplacement dans la direction définie par les *n* points d'image (110, 210), mesuré en unité de la distance p des points d'impression, est égal au nombre *n* des points d'image (110, 210).

18. Procédé pour l'illustration de plaques d'impression (18, 28) selon la revendication 17, **caractérisé en ce que** la distance *1* des points d'image (110, 210) est un multiple entier de la distance *p* des points d'impression des diodes laser (12).

19. Procédé pour l'illustration de plaques d'impression (18, 28) selon l'une des revendications 16 à 18, **caractérisé en ce que** la distance *1* des points d'image (110, 210), mesurée en unités de la distance *p* des points d'impression et le nombre des diodes laser (12) sont des nombres premiers entre eux.

20. Procédé pour l'illustration de plaques d'impression (18, 28) selon la revendication 19, **caractérisé par** la distance *l* des points d'image (110, 210) mesurée en unités de la distance *p* des points d'impression et le nombre des diodes laser (12) sont des nombres premiers entre eux.

21. Groupe d'impression, **caractérisé en ce que** le groupe d'impression présente au moins un dispositif pour l'illustration de plaques d'impression (18, 28) selon l'une des revendications 1 à 15.

22. Machine d'impression, **caractérisée en ce que** la machine d'impression présente au moins un groupe d'impression selon la revendication 21.
